(19) Europäisches Patentamt / European Patent Office / Office européen des brevets

(11) **EP 2 674 766 B1**

(12) **EUROPÄISCHE PATENTSCHRIFT**

(45) Veröffentlichungstag und Bekanntmachung des Hinweises auf die Patenterteilung:
**06.11.2019   Patentblatt 2019/45**

(51) Int Cl.:
**G01R 15/18** (2006.01)          **G01R 19/20** (2006.01)

(21) Anmeldenummer: **13169652.8**

(22) Anmeldetag: **29.05.2013**

(54) **Verfahren und Vorrichtung zur allstromsensitiven Strommessung**

Method and device for current measurement sensitive to all types of current

Procédé et dispositif de mesure du courant sensible à tous les types de courants

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.06.2012   DE 102012209782**

(43) Veröffentlichungstag der Anmeldung:
**18.12.2013   Patentblatt 2013/51**

(73) Patentinhaber: **Bender GmbH & Co. KG**
**35305 Grünberg (DE)**

(72) Erfinder: **Hackl, Dieter**
**35463 Fernwald (DE)**

(74) Vertreter: **advotec.**
**Patent- und Rechtsanwälte**
**Georg-Schlosser-Straße 6**
**35390 Gießen (DE)**

(56) Entgegenhaltungen:
**EP-A1- 1 542 025     EP-A2- 0 132 745**
**EP-A2- 0 579 462     CH-A- 270 675**
**FR-A1- 2 586 817     GB-A- 2 000 873**
**US-A- 4 280 162**

• **Kuznetsov: "Phase detector characteristic", , 28 March 2012 (2012-03-28), XP055490407, Retrieved from the Internet: URL:https://en.wikipedia.org/w/index.php?title=Phase_detector_characteristic&oldid=484324385**

**Beschreibung**

Die Erfindung betrifft ein Verfahren und eine Vorrichtung zur galvanisch getrennten, allstromsensitiven Strommessung, umfassend einen Messstromwandler mit einer Primärwicklung, durch welche ein zu messender Strom fließt, eine transformatorische Kopplung der Primärwicklung mit einer Sekundärwicklung über einen gemeinsamen magnetischen Fluss, der einen magnetischen Kreis mit mindestens einem Teilstück aus einem Werkstoff mit einer relativen Permeabilität bildet, wobei in der Sekundärwicklung eine der zeitlichen Änderung des primärseitigen Stroms proportionale erste Teilspannung induziert wird.

Verfahren und Vorrichtungen zur galvanisch getrennten Strommessung sind in der Funktion und Form von Differenzstrom-Überwachungsgeräten für elektrische Anlagen bekannt. Gemäß VDE-Bestimmung ist es die Aufgabe eines Differenzstrom-Überwachungsgerätes, elektrische Installationen oder Stromkreise auf das Auftreten eines Differenzstroms zu überwachen und durch einen Alarm anzuzeigen, wenn dieser einen festgelegten Wert überschreitet. Dabei werden alle aktiven Leiter des zu schützenden Leitungsabgangs als Primärwicklung durch einen Messstromwandler mit Sekundärwicklung geführt. Der Messstromwandler stellt einen magnetischen Kreis dar, in dem das von dem in der Primärwicklung fließenden Strom erzeugte magnetische Feld geführt und so mit der Sekundärwicklung transformatorisch über einen gemeinsamen magnetischen Fluss gekoppelt wird. Der geschlossene magnetische Kreis kann sich dabei aus mehreren Teilstücken unterschiedlicher Permeabilität zusammensetzen, beispielsweise aus einem Magnetkernmaterial mit hoher Permeabilität und einem Luftspalt, der stets die relative Permeabilität $\mu_{rel}$ = 1 aufweist.

Im fehlerfreien Stromversorgungssystem ist die vektorielle Summe aller Ströme und damit der Differenzstrom gleich Null, so dass in der Sekundärwicklung keine Spannung induziert wird. Fließt hingegen ein Fehlerstrom, z.B. infolge eines Isolationsfehlers, über Erde ab, so fließt durch den Messstromwandler ein Differenzstrom, dessen Magnetfeld im Falle einer zeitlichen Änderung sekundärseitig eine Spannung induziert, die detektiert und ausgewertet werden kann. Auf Grund des Induktionsprinzips ist eine derartige Anordnung nur in der Lage, zeitliche Änderungen des magnetischen Flusses und damit nur diese Flussänderungen verursachende primärseitige Stromänderungen zu detektieren.

An die elektrische Anlage angeschlossene Verbraucher wie beispielsweise elektrische Maschinen, die elektronische Halbleiterbauelemente wie Dioden oder Thyristoren in Gleichrichtern oder Frequenzumrichtern aufweisen, können allerdings auch Differenzströme erzeugen, die einen nicht rein sinusförmigen, sondern einen pulsierenden zeitlichen Verlauf besitzen oder als Gleich-Differenzstrom in Erscheinung treten. Eine allstromsensitive Strommessung ist daher in diesen Anwendungsbereichen anzustreben.

Aus dem Stand der Technik sind Verfahren zur allstromsensitiven Strommessung bekannt, die nach dem Prinzip der magnetischen Kompensation arbeiten. Dabei sind auf dem Stromwandlerkern zwei Sekundärwicklungen angeordnet, wobei der Messstromwandler als schwingungserzeugendes Element in einem Gegentaktoszillator integriert ist. Durch das Oszillatorprinzip wird die magnetische Kennlinie des Kerns ständig mit der Schwingfrequenz bis in den Sättigungsbereich durchlaufen. Dadurch werden Gleichstrommagnetisierungen kompensiert, wobei der durch den Oszillator fließende Kompensationsstrom proportional durch den Wechsel- und den Gleich-Differenzstrom beeinflusst wird und ausgewertet werden kann. Als nachteilig erweist sich bei diesem Verfahren, dass das weichmagnetische Kernmaterial wegen des Oszillatorbetriebs hohen Anforderungen genügen muss. Zudem sind vor allem bei größeren Messstromwandlern nur geringe Bandbreiten hinsichtlich der zu erfassenden Wechsel-Differenzströme zu erzielen.

Andere Verfahren zur allstromsensitiven Strommessung beruhen auf Kompensationsschaltungen in Verbindung mit dem Einsatz von Magnetfeldsensoren wie beispielsweise Hallsonden, magnetoresistiven Sensoren oder auf Fluxgate-Magnetometern. Derartige Anordnungen weisen oftmals einen nur geringen Dynamikbereich auf.

Aus der Offenlegungsschrift EP 1 542 025 A1 ist ein Stromsensor mit einer zeitlichen Veränderung der relativen Permeabilität bekannt. Dem Messprinzip liegt eine magnetische Messbrücke zugrunde, bei der sich die magnetischen Flüsse in ausbalanciertem Zustand durch unmittelbare Beeinflussung kompensieren.

Die Offenlegungsschrift EP 0 579 462 A2 zeigt einen Gleichstromsensor, der zwei senkrecht zueinander angeordnete Magnetkerne aufweist. Dabei wird in einer Erregerspule ein Wechselstrom eingespeist, der den Erregerkern periodisch in die Sättigung fährt und damit eine Änderung dessen relativer Permeabilität bewirkt. Dies hat zur Folge, dass der durch den zu messenden Gleichstrom erzeugte Fluss mit der doppelten Frequenz des Wechselstroms moduliert wird und eine Spannung induziert wird, aus der ein dem zu messenden Gleichstrom proportionaler Anteil gewonnen werden kann.

Schließlich existieren Verfahren zur Strommessung mit Shuntwiderständen, wobei die galvanische Trennung mit Trennverstärkern und eine Auswertung der Messgrößen mit Mitteln der digitalen Signalverarbeitung erfolgt. Allerdings kann sich insbesondere bei höheren Versorgungsspannungen im zu überwachenden Netz die Erfassung über Shuntwiderstände in Verbindung mit einer separaten galvanischen Trennung als kostspielige Lösung erweisen.

Der vorliegenden Erfindung liegt somit die Aufgabe zu Grunde, ein Verfahren und eine Vorrichtung zur allstromsensitiven Strommessung zu entwickeln, die insbesondere für die Messung von zeitlich konstanten primärseitigen Strömen (Gleich-Differenzströmen) sowohl eine hohe Messempfindlichkeit als auch einen großen Dynamikbereich aufweisen. Das Verfahren und die Vorrichtung sollen gleichermaßen für eine Anwendung in Stromversorgungssystem zur Differenzstrommessung wie für eine Anwendung zur einfachen Strommessung geeignet sein.

Diese Aufgabe wird durch ein Verfahren gemäß Anspruch 1 gelöst. Dabei wird durch eine zeitliche Änderung der relativen Permeabilität in dem das Teilstück bildenden Werkstoff in der Sekundärwicklung eine zweite Teilspannung induziert, die direkt proportional zu einem in der Primärwicklung zu messenden Gleichstrom ist.

Neben einer auf Grund der zeitlichen Änderung des Primärstroms ersten induzierten Teilspannung wird bei einem in der Primärwicklung fließenden Gleichstromanteil infolge der sich zeitlich ändernden relativen Permeabilität eine diesem Gleichstromanteil direkt proportionale zweite Teilspannung erzeugt.

Die erste induzierte Teilspannung ergibt sich in bekannter Weise nach dem Induktionsgesetz aus der zeitlichen Änderung des Primärstroms i :

$$u_{i_1}(t) = NA_{eff}\frac{\partial B_m}{\partial t} = NA_{eff}N\frac{\mu_{rel}\mu_0}{l_{eff}}\frac{\partial i}{\partial t} \quad \text{mit} \quad \frac{\partial B_m}{\partial t} = N\frac{\mu_{rel}\mu_0}{l_{eff}}\frac{\partial i}{\partial t}$$

$$(1),$$

mit $N$ = Windungszahl, $\mu_{rel}$ = relative Permeabilität (Permeabilitätszahl), $\mu_0$ = $4\pi10^{-7}$ Vs/Am (magnetische Feldkonstante), $A_{eff}$ = effektiver magnetischer Querschnitt, $l_{eff}$ = effektive magnetische Weglänge.

Ein zeitlich konstanter Primärstrom - also ein den Messstromwandler primärseitig durchfließender Gleich-Differenzstrom oder Gleichstrom - bewirkt keine Induktionsspannung. Der Wirkungsmechanismus nach Gleichung (1) ist daher nur zur Erfassung von Wechselgrößen geeignet. Erfindungsgemäß umfasst daher das beanspruchte Verfahren zur allstromsensitiven Strommessung einen zweiten Wirkungsmechanismus, der auf der zeitlichen Änderung der relativen Permeabilität in dem das Teilstück bildenden Werkstoff beruht und der eine zweite induzierte Teilspannung bewirkt, deren Amplitude direkt proportional zu einem in der Primärwicklung zu messenden Gleichstrom ist:

$$u_{i2}(t) = NA_{eff}\frac{\partial B_m}{\partial t} = NA_{eff}N\Delta I_{DC}\frac{\mu_0}{l_{eff}}\frac{\partial \mu_{rel}}{\partial t} \quad \text{mit} \quad \frac{\partial B_m}{\partial t} = N\Delta I_{DC}\frac{\mu_0}{l_{eff}}\frac{\partial \mu_{rel}}{\partial t}$$

$$(2),$$

wobei $\Delta I_{DC}$ den zu messenden Gleichstrom (Primärstrom) bezeichnet.

Aus Gleichung (2) ist ersichtlich, dass auch ein zeitlich konstanter Primärstrom durch das Auftreten einer Induktionsspannung detektiert werden kann, wenn sich die relative Permeabilität des Magnetwerkstoffs zeitlich ändert.

In weiterer bevorzugter Ausgestaltung erfolgt die zeitliche Änderung der relativen Permeabilität in dem das Teilstück bildenden Werkstoff durch einen Steuerstromwandler, der einen nicht mit dem magnetischen Fluss des Messstromwandlers gekoppelten magnetischen Steuerfluss in dem das Teilstück bildenden Werkstoff erzeugt.

Um die relative Permeabilität des Werkstoffs beeinflussen zu können, wird dieser von einem magnetischen Steuerfluss durchsetzt, der unabhängig von dem die Primär- und Sekundärwicklung des Messstromwandlers koppelnden magnetischen Fluss ist. Der Steuerfluss wird von einem Steuerstromwandler derart erzeugt und geführt, dass keine Kopplung zwischen dem magnetischen Kreis des Messstromwandlers und dem Steuerfluss auftritt. In der praktischen Umsetzung des Verfahrens kann dies dadurch erreicht werden, dass die Induktionslinien in dem Messstromwandler und die den Steuerfluss bildenden Induktionslinien in einem sich überschneidenden Teilstück orthogonal zueinander verlaufen.

Mit Vorteil wird der magnetische Steuerfluss in dem Steuerstromwandler mittels einer Steuerwicklung erzeugt, durch die ein zeitlich veränderlicher Steuerstrom mit einer einstellbaren Frequenz fließt.

Das zur Änderung der relativen Permeabilität erforderliche Magnetfeld kann in einfacher Weise durch eine (Steuer-)Stromwicklung erzeugt und mittels eines Steuerwandler-Magnetkerns durch das überschneidende Teilstück geleitet werden. Die zeitliche Änderung des Steuerstroms erfolgt dadurch, dass der Steuerstrom ein Wechselstrom einstellbarer Frequenz bildet. Da der magnetische Fluss in dem Messstromwandler und der magnetische Fluss in dem Steuerstromwandler elektromagnetisch entkoppelt sind - die magnetischen Induktionslinien in dem gemeinsamen Teilstück verlaufen orthogonal zueinander - besteht zwischen der Steuerwicklung und der Sekundärwicklung des Messstromwandlers (Messwicklung) keine transformatorische Kopplung.

In vorteilhafter Weise bewirkt der zeitlich veränderliche Steuerstrom in Verbindung mit einer nichtlinearen magnetischen Kennlinie in dem das Teilstück bildenden Werkstoff durch Veränderung des magnetischen Arbeitspunktes eine aussteuerungsabhängige Änderung der relativen Permeabilität. In Abhängigkeit des Stroms durch die Steuerwicklung und der sich daraus ergebenden magnetischen Feldstärke kann über die sich entsprechend der nichtlinearen magnetischen Kennlinie einstellende Induktion der Arbeitspunkt und damit die relative Permeabilität des Werkstoffs in dem sich überschneidenden Teilstück beeinflusst werden. Es gilt:

$$\mu_{rel}(t) = f(i_{st}(t)) \qquad (3),$$

wobei $i_{st}(t)$ der zeitabhängige Steuerstrom ist.

An einem Bürdenwiderstand der Sekundärwicklung des Messstromwandlers ist eine Summen-Messspannung auf Grund der sich überlagernden ersten und zweiten induzierten Teilspannungen erfassbar. Die induzierten Teilspannungen bewirken in einem geschlossenen Sekundärstromkreis des Messstromwandlers einen Stromfluss, der an dem Bürdenwiderstand zu einem Spannungsabfall führt, der überlagert als Summen-Messspannung abgreifbar ist.

Die erfasste Summen-Messspannung wird synchron zu dem zeitlich veränderlichen Steuerstrom bewertet.

Die Bewertung der erfassten Summen-Messspannung erfolgt durch eine zu dem zeitlich veränderlichen Steuerstrom synchrone Spannung, mit der die an dem Bürdenwiderstand erfasste Summen-Messspannung multipliziert wird und ein zweites, dem zu messenden Gleichstrom proportionales Messsignal ergibt.

Diese Bewertung entspricht einer Synchrongleichrichter-Schaltung, mit der der durch die zweite induzierte Spannung hervorgerufene Anteil an der Summen-Messspannung gleichgerichtet wird. Auf diese Weise erhält man ein dem Gleichstrom proportionales Messsignal.

Mit Vorteil erfolgt eine Filterung der erfassten Summen-Messspannung mit einer Filterschaltung, die als Bandsperre bei der eingestellten Frequenz des veränderlichen Steuerstroms ausgeführt ist und ein erstes, dem zu messenden Wechselstrom proportionales Messsignal ergibt.

In einem zur Synchron-Gleichrichtung parallelen Signalpfad erfolgt eine Filterung der erfassten Summen-Messspannung. Die Filterschaltung sperrt störende Signalanteile in der Summen-Messspannung, die auf Grund der zweiten induzierten Spannung entstehen, sodass an dem Filterausgang ein erstes Messsignal erzeugt wird, das ausschließlich auf die erste induzierte Spannung zurückzuführen ist und daher ein dem zu messenden Wechsel-Differenzstrom bzw. dem zu messenden Wechselstrom proportionales Messsignal widerspiegelt.

Anschließend werden das erste Messsignal und das zweite Messsignal addiert, um ein Ausgangssignal zu erhalten, das das Ergebnis der allstromsensitiven Strommessung anzeigt.

Zur besseren Erkennung des ersten und des zweiten Messsignals kann die Frequenz des Steuerstroms zyklisch zwischen mindestens zwei Frequenzen umgeschaltet werden.

Diese Maßnahme ermöglicht, dass in dem Fall, in dem die Frequenz des Steuerstroms (zur Erzeugung des zweiten Messsignals) und die Frequenz des transformatorisch übertragenen Signals (erstes Messsignal) nahe beieinanderliegen und sich die Messsignale gegenseitig stören können, durch zyklisches Umschalten der Frequenz des Steuerstroms die Messsignale besser unterscheidbar sind, da sich infolge des Frequenzwechsels sich das zweite, den Gleich-Differenzstrom repräsentierende Messsignal ebenfalls sprungförmig und synchron zu dem Frequenzwechsel ändert.

Die der Erfindung zu Grunde liegende Aufgabe wird weiterhin durch eine Vorrichtung gemäß Anspruch 7 gelöst.

Korrespondierend zu den Merkmalen des beanspruchten Verfahrens weist die erfindungsgemäße Vorrichtung daher einen Steuerstromwandler auf, der einen von dem magnetischen Fluss in dem Messstromwandler unabhängigen, zeitlich veränderlichen Steuerfluss erzeugt. Dazu bilden die geschlossenen Induktionslinien dieses Steuerflusses einen magnetischen Kreis, der in Bezug auf die Lage des Messstromwandlers derart angeordnet ist, dass ein Teilstück des magnetischen Kreises des Messstromwandlers als gemeinsames Teilstück mit dem magnetischen Kreis des Steuerstromwandlers ausgebildet ist. Auf diese Weise wird das gemeinsame Teilstück sowohl von dem in dem Messstromwandler erzeugten magnetischen Fluss, als auch von dem in dem Steuerstromwandler erzeugten magnetischen Fluss durchsetzt. Der das gemeinsame Teilstück bildende Werkstoff weist eine nichtlineare magnetische Kennlinie auf, sodass durch Veränderung des magnetischen Arbeitspunktes entlang dieser Kennlinie eine aussteuerungsabhängige Änderung der relativen Permeabilität bewirkt wird und damit gemäß oben angeführter Gleichung (2) in der Sekundärwicklung eine zweite Teilspannung induziert wird, die direkt proportional zu einem in der Primärwicklung zu messenden Gleichstrom ist.

In weiterer vorteilhafter Ausgestaltung sind zur Entkopplung des magnetischen Flusses in dem Messstromwandler und des magnetischen Flusses in dem Steuerstromwandler der Messstromwandler und der Steuerstromwandler derart angeordnet, dass die magnetischen Induktionslinien in dem gemeinsamen Teilstück der beiden magnetischen Kreise orthogonal zueinander verlaufen.

Die magnetischen Flüsse in dem Messstromwandler und in dem Steuerstromwandler sind damit unabhängig voneinander, sodass die Veränderung des magnetischen Arbeitspunktes und damit der relativen Permeabilität keine die Messung verfälschende Rückwirkung auf den magnetischen Fluss in dem Messstromwandler hat. Zwischen der Sekundärwicklung des Messstromwandlers und einer auf dem Steuerstromwandler aufgebrachten Steuerwicklung (siehe unten) besteht auf Grund der orthogonalen magnetischen Induktionsverläufe keine transformatorische Kopplung.

Bevorzugterweise ist die Verbindung zwischen Messstromwandler und Steuerstromwandler in dem gemeinsamen Teilstück der beiden magnetischen Kreise mit oder ohne Luftspalt ausgebildet.

Eine Ausführung mit Luftspalt hat den Vorteil, dass der Messstromwandler mit einem herkömmlichen Magnetkern gefertigt werden kann und Messstrom- wie Steuerstromwandler getrennt bewickelt werden können. Eine Ausführung ohne Luftspalt ist hingegen mit Ferritmaterial kundenspezifisch herstellbar und besitzt den Vorteil, dass auch bei geringer Steuerleistung eine größere Änderung der relativen Permeabilität erreicht werden kann.

Der Steuerstromwandler weist eine Steuerwicklung auf, durch die ein zeitlich veränderlicher Steuerstrom mit einer einstellbaren Frequenz fließt.

Der Steuerstrom erzeugt ein magnetisches Feld, sodass eine magnetische Induktion entsprechend der nichtlinearen magnetischen Kennlinie durchfahren wird. Die zeitliche Änderung der Permeabilität in dem das gemeinsame Teilstück bildenden Werkstoff erfolgt durch Veränderung des magnetischen Arbeitspunktes damit aussteuerungsabhängig gemäß obiger Gleichung (3). Da zudem in dem Steuerstromwandler keine Kopplung zu einem Bürdenwiderstand besteht - der Steuerstromwandler besitzt nur die Steuerwicklung als einzige Wicklung - kann die erforderliche Änderung der relativen Permeabilität bereits mit kleinen Änderungen des Steuerstroms bewirkt werden.

In weiterer Ausgestaltung umfasst die Vorrichtung eine Signalverarbeitungseinrichtung, die zur Erfassung einer Summen-Messspannung einen Bürdenwiderstand in der Sekundärwicklung des Messstromwandlers aufweist.

An dem Bürdenwiderstand können als überlagerte Messspannungen Spannungen abgegriffen und anschließend weiter verarbeitet werden, die sich auf Grund der ersten induzierten Teilspannung und auf Grund der zweiten induzierten Teilspannung in dem Messstromwandler ergeben.

Die Signalverarbeitungseinrichtung weist eine Bewertungsschaltung zur Bewertung der erfassten Summen-Messspannung auf.

Die Bewertungsschaltung weist dabei eine zu dem veränderlichen Steuerstrom synchrongesteuerte Spannungsquelle auf, deren Ausgangsspannung einem Multiplizierer zugeführt und mit der erfassten Summen-Messspannung multipliziert wird.

Um ein dem zu messenden Gleichstrom proportionales Messsignal (zweites Messsignal) zu erhalten, wird der durch die zweite induzierte Spannung hervorgerufene Anteil an der Summen-Messspannung synchron zu dem Verlauf des Steuerstroms bewertet (Synchrongleichrichter-Schaltung).

Weiterhin weist die Signalverarbeitungseinrichtung eine Filterschaltung auf, an deren Eingang die erfasste Summen-Messspannung anliegt und die als Bandsperre bei der eingestellten Frequenz des veränderlichen Steuerstroms ausgeführt ist.

Die Bandsperre verhindert, dass störende Signalanteile mit der Frequenz des Steuerstroms den Signalweg zur Ermittlung des ersten Messsignals passieren, um dieses Messsignal, das dem zu messenden Wechselstrom proportional ist, nicht zu verfälschen.

In bevorzugter Ausführung besitzt der Steuerstromwandler eine möglichst kurze magnetische Weglänge. Für die erforderliche Änderung der relativen Permeabilität sind dann nur geringe Änderungen des Steuerstroms erforderlich, was vor allem bei sehr großen Messstromwandlern von Vorteil ist.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:

**Fig. 1:** einen prinzipiellen Aufbau einer erfindungsgemäßen Vorrichtung,

**Fig. 2:** ein funktionales Blockdiagramm der Signalverarbeitung.

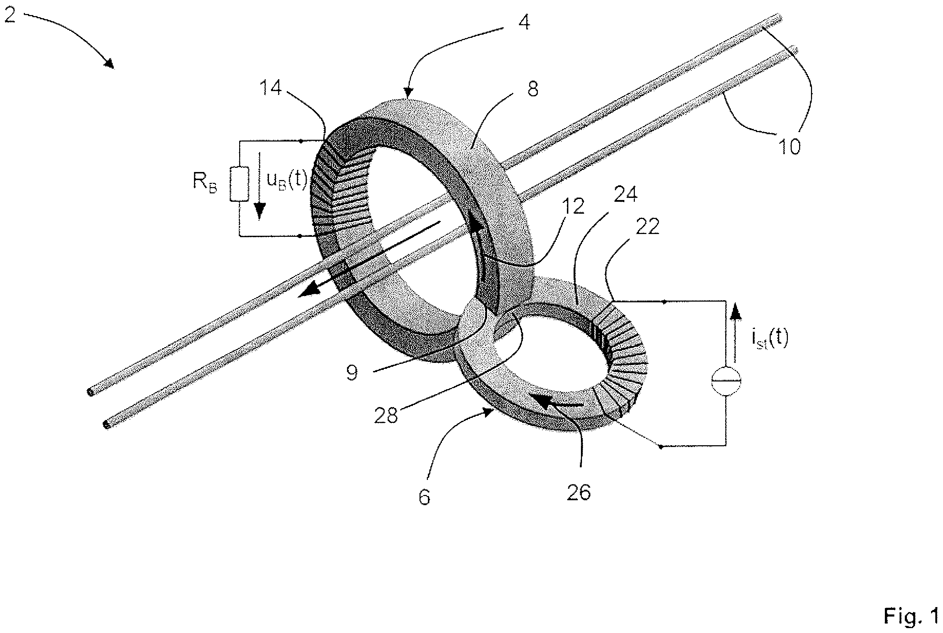

**Fig.1** zeigt einen prinzipiellen Aufbau einer erfindungsgemäßen Vorrichtung 2 zur galvanisch getrennten, allstromsensitiven Strommessung. Die Vorrichtung 2 besteht aus einem Messstromwandler 4 und einem Steuerstromwandler 6. Der Messstromwandler 4 umfasst einen herkömmlichen, ringförmigen Magnetkern 8 mit einem Luftspalt 9. Alternativ zu dem dargestellten Ausführungsbeispiel ist auch eine Ausführung des Magnetkerns 8 aus Ferritmaterial ohne Luftspalt 9 möglich. Durch den Messstromwandler 4 ist eine als Primärwicklung 10 wirkende elektrische Leitung 10 mit zwei aktiven Leitern geführt. Transformatorisch über einen magnetischen Fluss 12 in dem Magnetkern 8 mit der Primärwicklung 10 gekoppelt, ist eine Sekundärwicklung 14. Zur Messung einer zu den induzierten Spannungen proportionalen (Summen-)Messspannung $u_B(t)$ ist die Sekundärwicklung 14 mit einem Bürdenwiderstand $R_B$ abgeschlossen.

Der Steuerstromwandler 6 weist eine Steuerwicklung 22 auf, durch die ein zeitabhängiger Steuerstrom $i_{st}(t)$ fließt. Der Steuerstrom $i_{st}(t)$ erzeugt in dem geschlossenen Ringkern 24 des Steuerstromwandlers 6 einen magnetischen Fluss 26. Dabei ist der Steuerstromwandler 6 so angeordnet, dass der Ringkern 24 des Steuerstromwandlers 6 durch den Luftspalt 9 des Messstromwandlers 4 geführt ist und den magnetischen Kreis des Messstromwandlers 4 schneidet. Somit bildet der in dem Luftspalt 9 befindliche Teil des Steuerwandlerringkerns 24 ein gemeinsames Teilstück 28 des Messstromwandler-Magnetkreises und des Steuerstromwandler-Magnetkreises. Der Werkstoff des gemeinsamen Teilstücks 28 wird sowohl von dem magnetischen Fluss 12 des Messstromwandlers 4, als auch von dem magnetischen Fluss 26 des Steuerstromwandlers 6 durchsetzt, wobei die jeweiligen Induktionslinien orthogonal zueinander verlaufen und damit keine Kopplung zwischen den in den jeweiligen Magnetkernen 8, 24 auftretenden magnetischen Flüssen 12, 26 besteht.

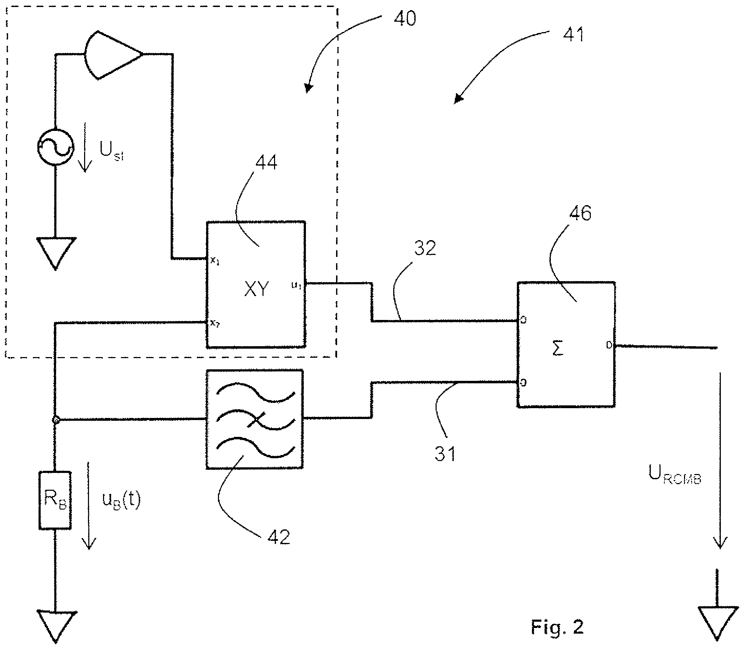

Durch den zeitabhängigen Steuerstrom $i_{st}(t)$ kann nun der magnetische Arbeitspunkt des das gemeinsame Teilstück 28 bildenden Werkstoffs verändert werden, wodurch sich eine entsprechend der magnetischen Kennlinie des Werkstoffs aussteuerungsabhängige Änderung der relativen Permeabilität $\mu_{rel}$ ergibt. Somit ist auch gemäß oben stehender Gleichung (2) bei einem in der Leitung 10 fließenden Gleichstrom an dem Bürdenwiderstand $R_B$ ein diesem Gleichstrom proportionales Messsignal (zweites Messsignal 32, Fig. 2) erfassbar. Diesem zweiten Messsignal 32 überlagert sich ein nach oben stehender Gleichung (1) ableitbares, infolge eines zu messenden Wechselstromes entstehendes, erstes Messsignal 31 (Fig. 2), sodass an dem Bürdenwiderstand ein Summen-Messsignal $u_B(t)$ zur Verfügung steht.

**Fig. 2** zeigt ein funktionales Blockdiagramm der Signalverarbeitung 41. Das an dem Bürdenwiderstand $R_B$ abgreifbare Summen-Messsignal $u_B(t)$ wird parallel einer Bewertungsschaltung 40 und einer Filterschaltung 42 zugeführt. Die Bewertungsschaltung 40 besteht aus einem Multiplizierer 44, der das Summen-Messsignal $u_B(t)$ und eine mit dem Steuerstrom $i_{st}(t)$ vorzeichensynchrone Steuerspannung $U_{st}$ miteinander multipliziert. Als Ergebnis dieser Synchron-Gleichrichtung erscheint am Multipliziererausgang ein Messsignal, dessen Amplitude direkt proportional zu dem in der Leitung 10 fließenden Gleichstrom ist (zweites Messsignal 32). Die Filterschaltung 42 ist als Bandsperre 42 realisiert, die Signalanteile im Bereich der Frequenz des Steuerstroms $i_{st}(t)$ unterdrückt. Damit wird vermieden, dass Signalanteile des zweiten Messsignals 32 zusätzlich auf das zur Erkennung von Wechselströmen vorgesehene erste Messsignal 31 einwirken und damit zu einer Verfälschung des Messergebnisses führen. An dem Ausgang der Bandsperre 42 ergibt sich ein zu dem zu messenden Wechselstrom proportionales erstes Messsignal 31, das anschließend in einem Addierer 46 mit dem zweiten Messsignal 32 zusammengefasst ein Ausgangsignal $U_{RCMB}$ ergibt.

Mit dem erfindungsgemäßen Verfahren und einer dieses Verfahren realisierenden Vorrichtung steht eine allstromsensitive Strommessung mit einer Kombination aus großer Bandbreite und hoher Messempfindlichkeit zur Verfügung. Die Messung kann sowohl zur Strommessung von Einzelleitern als auch zur Differenzstrommessung in Stromsystemen mit mehreren aktiven Leitern angewendet werden.

## Patentansprüche

**1.** Verfahren zur galvanisch getrennten, allstromsensitiven Differenzstrommessung in einem Stromversorgungssystem, umfassend einen Messstromwandler (4) mit einer als Primärwicklung (10) wirkenden Leitung des Stromversorgungssystems, durch welche ein zu messender Strom fließt, eine transformatorische Kopplung der Primärwicklung (10) mit einer Sekundärwicklung (14) über einen gemeinsamen magnetischen Fluss (12), der einen magnetischen Kreis mit mindestens einem Teilstück (28) aus einem Werkstoff mit einer relativen Permeabilität bildet, wobei in der Sekundärwicklung (14) eine der zeitlichen Änderung des primärseitigen Stroms proportionale erste Teilspannung induziert wird, wobei durch eine zeitliche Änderung der relativen Permeabilität in dem das Teilstück (28) bildenden Werkstoff in der Sekundärwicklung (14), die durch einen Steuerstrom ($i_{st}(t)$) erfolgt, eine zweite Teilspannung induziert wird, die direkt proportional zu einem in der Primärwicklung (10) zu messenden Gleichstrom ist und wobei an einem Bürdenwiderstand ($R_B$) der Sekundärwicklung (14) des Messstromwandlers (4) eine Summen-Messspannung ($u_B(t)$) auf Grund der sich überlagernden ersten und zweiten induzierten Teilspannungen erfassbar ist und die erfasste Summen-Messspannung ($u_B(t)$) synchron zu dem zeitlich veränderlichen Steuerstrom ($i_{st}(t)$) bewertet wird, wobei die Bewertung der erfassten Summen-Messspannung ($u_B(t)$) durch eine zu dem zeitlich veränderlichen Steuerstrom ($i_{st}(t)$) synchrone Spannung ($U_{st}$) erfolgt, mit der die an dem Bürdenwiderstand ($R_B$) erfasste Summen-Messspannung ($u_B(t)$) multipliziert wird und ein zweites, dem zu messenden Gleichstrom proportionales Messsignal (32) ergibt, wobei zur besseren Erkennung eines ersten Messsignals (31), das auf die erste induzierte Teilspannung zurückzuführen ist, und des zweiten Messsignals (32) eine Frequenz des Steuerstroms ($i_{st}(t)$) zyklisch zwischen mindestens zwei Frequenzen umgeschaltet wird.

**2.** Verfahren nach Anspruch 1,
**dadurch gekennzeichnet,**
**dass** die zeitliche Änderung der relativen Permeabilität in dem das Teilstück (28) bildenden Werkstoff durch einen Steuerstromwandler (6) erfolgt, der einen nicht mit dem magnetischen Fluss (12) des Messstromwandlers (4) gekoppelten magnetischen Steuerfluss (26) in dem das Teilstück (28) bildenden Werkstoff erzeugt.

**3.** Verfahren nach Anspruch 2,
**dadurch gekennzeichnet,**
**dass** der magnetische Steuerfluss (26) in dem Steuerstromwandler (6) mittels einer Steuerwicklung (22) erzeugt wird, durch die ein zeitlich veränderlicher Steuerstrom ($i_{st}(t)$) mit einer einstellbaren Frequenz fließt.

4. Verfahren nach Anspruch 3,
**dadurch gekennzeichnet,**
**dass** der zeitlich veränderliche Steuerstrom ($i_{st}(t)$) in Verbindung mit einer nichtlinearen magnetischen Kennlinie in dem das Teilstück (28) bildenden Werkstoff durch Veränderung des magnetischen Arbeitspunktes eine aussteuerungsabhängige Änderung der relativen Permeabilität bewirkt.

5. Verfahren nach einem der Ansprüche 1 bis 4,
**dadurch gekennzeichnet,**
**dass** eine Filterung der erfassten Summen-Messspannung ($u_B(t)$) mit einer Filterschaltung erfolgt, die als Bandsperre bei der eingestellten Frequenz des veränderlichen Steuerstroms ($i_{st}(t)$) ausgeführt ist und das erste, dem zu messenden Wechselstrom proportionale Messsignal (31) ergibt.

6. Verfahren nach Anspruch 5,
**dadurch gekennzeichnet,**
**dass** das erste Messsignal (31) und das zweite Messsignal (32) addiert werden, um ein Ausgangssignal ($U_{RCMB}$) zu erhalten, das das Ergebnis der allstromsensitiven Strommessung anzeigt .

7. Vorrichtung zur galvanisch getrennten, allstromsensitiven Differenzstrommessung in einem Stromversorgungssystem, bestehend aus einem Messstromwandler (4) mit einer als Primärwicklung (10) wirkenden Leitung des Stromversorgungssystems, durch welche ein zu messender Strom fließen kann, einer transformatorischen Kopplung der Primärwicklung (10) mit einer Sekundärwicklung (14) über einen gemeinsamen magnetischen Fluss (12), der einen magnetischen Kreis mit mindestens einem Teilstück (28) aus einem Werkstoff mit einer relativen Permeabilität bildet, wobei in der Sekundärwicklung (14) eine der zeitlichen Änderung des primärseitigen Stroms proportionale erste Teilspannung induziert werden kann, umfassend einen Steuerstromwandler (6) mit einer Steuerwicklung (22) und einem zeitlich veränderlichen magnetischen Steuerfluss (26), der nicht mit dem magnetischen Fluss (12) in dem Messstromwandler (4) gekoppelt ist, wobei der Steuerstromwandler (6) so eingerichtet ist, dass durch die Steuerwicklung (22) ein zeitlich veränderlicher Steuerstrom ($i_{st}(t)$) mit einer einstellbaren Frequenz fließt, und einen magnetischen Kreis derart bildet, dass das Teilstück (28) des magnetischen Kreises des Messstromwandlers (4) als gemeinsames Teilstück (28) mit dem magnetischen Kreis des Steuerstromwandlers (6) ausgebildet ist, sodass der das gemeinsame Teilstück (28) bildende Werkstoff von dem Steuerfluss (26) durchsetzt wird und in Verbindung mit einer nichtlinearen magnetischen Kennlinie in dem das Teilstück (28) bildenden Werkstoff eine Änderung der relativen Permeabilität und damit in der Sekundärwicklung (14) eine zweite induzierte Teilspannung bewirkt, und eine Signalverarbeitungseinrichtung (41), die zur Erfassung einer Summen-Messspannung ($u_B(t)$) einen Bürdenwiderstand ($R_B$) in der Sekundärwicklung (14) des Messstromwandlers (4) aufweist, wobei die Signalverarbeitungseinrichtung (41) eine Bewertungsschaltung (40) zur Bewertung der erfassten Summen-Messspannung ($u_B(t)$) aufweist und die Bewertungsschaltung (40) eine zu dem veränderlichen Steuerstrom ($i_{st}(t)$) synchrongesteuerte Spannungsquelle ($U_{st}$) und einen Multiplizierer (44) aufweist, wobei die Bewertungsschaltung (40) so eingerichtet ist, dass die Ausgangsspannung der Spannungsquelle ($U_{st}$) dem Multiplizierer (44) zugeführt und mit der erfassten Summen-Messspannung ($u_B(t)$) multipliziert wird und wobei die Vorrichtung so eingerichtet ist, dass zur besseren Erkennung eines ersten Messsignals (31), das auf die erste induzierte Teilpannung zurückzuführen ist, und des zweiten Messsignals (32) die Frequenz des Steuerstroms ($i_{st}(t)$) zyklisch zwischen mindestens zwei Frequenzen umgeschaltet wird.

8. Vorrichtung nach Anspruch 7,
**dadurch gekennzeichnet,**
**dass** zur Entkopplung des magnetischen Flusses (12) in dem Messstromwandler (4) und des magnetischen Flusses (26) in dem Steuerstromwandler (6) der Messstromwandler (4) und der Steuerstromwandler (6) derart angeordnet sind, dass die magnetischen Induktionslinien in dem gemeinsamen Teilstück (28) der beiden magnetischen Kreise orthogonal zueinander verlaufen.

9. Vorrichtung nach Anspruch 7 oder 8,
**dadurch gekennzeichnet,**
**dass** die Verbindung zwischen Messstromwandler (4) und Steuerstromwandler (6) in dem gemeinsamen Teilstück (28) der beiden magnetischen Kreise mit oder ohne Luftspalt (9) ausgebildet ist.

10. Vorrichtung nach einem der Ansprüche 7 bis 9,

**dadurch gekennzeichnet,**
**dass** die Signalverarbeitungseinrichtung (41) eine Filterschaltung (42) aufweist, an deren Eingang die erfasste Summen-Messspannung ($u_B(t)$) anliegt und die als Bandsperre (42) bei der eingestellten Frequenz des veränderlichen Steuerstroms ($i_{st}(t)$) ausgeführt ist.

**11.** Vorrichtung nach einem der Ansprüche 7 bis 10,
**dadurch gekennzeichnet,**
**dass** der Steuerstromwandler (6) eine möglichst kurze magnetische Weglänge besitzt.

**Claims**

**1.** A method for galvanically isolated, AC/DC sensitive differential current measurement in a power supply system, comprising a measuring current transformer (4) having a line of the power supply system functioning as primary winding (10) through which a current to be measured is flowing, a transformer coupling between the primary winding (10) and a secondary winding (14) via a shared magnetic flux (12) which forms a magnetic circuit having at least one segment (28) made from a material of relative permeability, wherein in the secondary winding (14) a first partial voltage proportional to the change in time of the primary-side current is induced, wherein, due to a change in time of the relative permeability in the material forming the segment (28), which is effected by a control current ($i_{st}(t)$), a second partial voltage is induced in the secondary winding (14), said second partial voltage being directly proportional to a direct current to be measured in the primary winding (10), and wherein, at a load resistance ($R_B$) of the secondary winding (14) of the measuring current transformer (4), a sum measuring voltage ($u_B(t)$) can be registered due to the first and second induced partial voltage superimposing each other and the registered sum measuring voltage ($u_B(t)$) is assessed synchronously to the temporally changeable control current ($i_{st}(t)$), wherein the assessment of the registered sum measuring voltage ($u_B(t)$) is effected by means of a voltage ($U_{st}$) which is synchronous to the temporally changeable control current ($i_{st}(t)$) and by which the sum measuring voltage ($u_B(t)$) registered at the load resistance ($R_B$) is multiplied, resulting in a second measuring signal (32) proportional to the direct current to be measured, wherein, for the improved registration of a first measuring signal (31) which can be attributed to the first induced partial voltage and the second measuring signal (32), a frequency of the control current ($i_{st}(t)$) is switched cyclically between at least two frequencies.

**2.** The method according to claim 1,
**characterized in that**
the change in time of the relative permeability in the material forming the segment (28) is effected by a control current transformer (6) which generates a magnetic control flux (26) in the material forming the segment (28), the magnetic control flux (26) not being coupled to the magnetic flux (12) of the measuring current transformer (4).

**3.** The method according to claim 2,
**characterized in that**
the magnetic control flux (26) is generated in the control current transformer (6) by means of a control winding (22) through which a temporally changeable control current ($i_{st}(t)$) with an adjustable frequency is flowing.

**4.** The method according to claim 3,
**characterized in that**
the temporally changeable control current ($i_{st}(t)$) in connection with a nonlinear magnetic characteristic curve causes a modulation-dependent change of the relative permeability in the material forming the segment (28) by changing the magnetic working point.

**5.** The method according to any of the claims 1 to 4,
**characterized in that**
a filtering of the registered sum measuring voltage ($u_B(t)$) is effected by means of a filter circuit, which is realized as a band rejection filter at the set frequency of the changeable control current ($i_{st}(t)$), resulting in the first measuring signal (31) proportional to the alternating current to be measured.

**6.** The method according to claim 5,
**characterized in that**
the first measuring signal (31) and the second measuring signal (32) are added to obtain an output signal ($U_{RCMB}$) which displays the result of the AC/DC sensitive current measurement.

**7.** A device for galvanically isolated, AC/DC sensitive differential current measurement in a power supply system, comprising a measuring current transformer (4) having a line of the power supply system functioning as primary winding (10) through which a current to be measured can be flowing, a transformer coupling between the primary winding (10) and a secondary winding (14) via a shared magnetic flux (12) which forms a magnetic circuit having at least one segment (28) made from a material of relative permeability, wherein in the secondary winding (14) a first partial voltage proportional to the change in time of the primary-side current can be induced, comprising a control current transformer (6) having a control winding (22) and a temporally changeable magnetic control flux (26) which is not coupled to the magnetic flux (12) in the measuring current transformer (4), wherein the control current transformer (6) is set in such a manner that a temporally changeable control current ($i_{st}(t)$) having an adjustable frequency is flowing through the control winding (22), and forms a magnetic circuit in such a manner that the segment (28) of the magnetic circuit of the measuring current transformer (4) is formed as a shared segment (28) with the magnetic circuit of the control current transformer (6) so that the material forming the shared segment (28) is permeated by the control flux (26) and in connection with a nonlinear magnetic characteristic curve causes a change of the relative permeability in the material forming the segment (28) and thus a second induced partial voltage in the secondary winding (14), and a signal processing means (41), which, for registering a sum measuring voltage ($u_B(t)$), has a load resistance ($R_B$) in the secondary winding (14) of the measuring current transformer (4), wherein the signal processing means (41) has an assessment circuit (40) for assessing the registered sum measuring voltage ($u_B(t)$) and the assessment circuit (40) has a voltage source ($U_{st}$) controlled synchronously to the changeable control current ($i_{st}(t)$) and a multiplier (44), wherein the assessment circuit (40) is set in such a manner that the output voltage of the voltage source ($U_{st}$) is supplied to the multiplier (44) and multiplied by the registered sum measuring voltage ($u_B(t)$), and the device is set in such a manner that, for the improved registration of a first measuring signal (31), which is to be attributed to the first induced partial voltage, and of the second measuring signal (32), the frequency of the control current ($i_{st}(t)$) is switched cyclically between at least two frequencies.

**8.** The device according to claim 7,
**characterized in that**
for the decoupling of the magnetic flux (12) in the measuring current transformer (4) and of the magnetic flux (26) in the control current transformer (6), the measuring current transformer (4) and the control current transformer (6) are arranged in such a manner that the magnetic induction lines in the shared segment (28) of the two magnetic circuits run orthogonally to each other.

**9.** The device according to claim 7 or 8,
**characterized in that**
the connection between the measuring current transformer (4) and the control current transformer (6) in the shared segment (28) of the two magnetic circuits is formed with or without an air gap (9).

**10.** The device according to any one of the claims 7 to 9,
**characterized in that**
the signal processing means (41) has a filter circuit (42) to the input of which the registered sum measuring voltage ($u_B(t)$) is applied and which is formed as a band rejection filter (42) at the set frequency of the changeable control current ($i_{st}(t)$).

**11.** The device according to any of the claims 7 to 10,
**characterized in that**
the control current transformer (6) has a magnetic path length as short as possible.


**Revendications**

**1.** Procédé pour la mesure de courant différentiel galvaniquement isolée et sensible à tous les courants dans un système d'alimentation électrique, comprenant un transformateur de courant de mesure (4) ayant une ligne du système d'alimentation électrique agissant comme enroulement primaire (10) par laquelle circule un courant à mesurer, un couplage transformateur entre l'enroulement primaire (10) et un enroulement secondaire (14) via un flux magnétique (12) commun qui forme un circuit magnétique ayant au moins un segment (28) constitué d'un matériau ayant une perméabilité relative, dans lequel une première tension partielle proportionnelle au changement temporel du courant côté primaire est induite dans l'enroulement secondaire (14), dans lequel, à cause d'un changement temporel de la perméabilité relative dans le matériau formant le segment (28), qui est effectué par un courant de commande ($i_{st}(t)$), une deuxième tension partielle est induite dans l'enroulement secondaire (14), ladite deuxième tension partielle étant directement proportionnelle à un courant continu à mesurer dans l'enroulement primaire (10), et dans lequel, à une résistance de charge ($R_B$) de l'enroulement secondaire (14) du transformateur de courant de mesure (4), une tension de mesure de la somme ($u_B(t)$) peut être enregistrée à cause de la première et la deuxième tension partielle induite qui se superposent l'une à l'autre, et la tension de mesure de la somme ($u_B(t)$) enregistrée est évaluée de manière synchrone au courant de commande ($i_{st}(t)$) variable dans le temps, dans lequel l'évaluation de la tension de mesure de la somme ($u_B(t)$) enregistrée s'effectue par une tension ($U_{st}$) qui est synchrone au courant de commande ($i_{st}(t)$) variable dans le temps et avec laquelle la tension de mesure de la somme ($u_B(t)$) enregistrée sur la résistance de charge ($R_B$) est multipliée ce qui résulte en un deuxième signal de mesure (32) proportionnel au courant continu à mesurer, dans lequel, afin de mieux enregistrer un premier signal de mesure (31) qui peut être attribué à la première tension partielle induite et le deuxième signal de mesure (32), une fréquence du courant de commande ($i_{st}(t)$) est commutée cycliquement entre au moins deux fréquences.

2. Procédé selon la revendication 1,
   **caractérisé en ce que**
   le changement temporel de la perméabilité relative dans le matériau formant le segment (28) s'effectue par un transformateur de courant de commande (6) qui génère un flux de commande (26) magnétique dans le matériau formant le segment (28), le flux de commande (26) magnétique n'étant pas couplé avec le flux magnétique (12) du transformateur de courant de mesure (4).

3. Procédé selon la revendication 2,
   **caractérisé en ce que**
   le flux de commande (26) magnétique est généré dans le transformateur de courant de commande (6) au moyen d'un enroulement de commande (22) par laquelle circule un courant de commande ($i_{st}(t)$) variable dans le temps avec une fréquence réglable.

4. Procédé selon la revendication 3,
   **caractérisé en ce que**
   le courant de commande ($i_{st}(t)$) variable dans le temps provoque, en relation avec une courbe caractéristique magnétique non linéaire un changement en fonction de la modulation de la perméabilité relative dans le matériau formant le segment (28) en changeant le point de fonctionnement magnétique.

5. Procédé selon l'une quelconque des revendications 1 à 4,
   **caractérisé en ce qu'**
   un filtrage de la tension de mesure de la somme ($u_B(t)$) s'effectue au moyen d'un circuit de filtrage qui est réalisé comme filtre coupe-bande à la fréquence réglée du courant de commande ($i_{st}(t)$) variable et qui résulte en le premier signal de mesure (31) proportionnel au courant alternatif à mesurer.

6. Procédé selon la revendication 5,
   **caractérisé en ce que**
   le premier signal de mesure (31) et le deuxième signal de mesure (32) son additionnés pour obtenir un signal de sortie ($U_{RCMB}$) qui affiche le résultat de la mesure de courant sensible à tous les courants.

7. Dispositif pour la mesure de courant différentiel galvaniquement isolée et sensible à tous les courants dans un système d'alimentation électrique, comprenant un transformateur de courant de mesure (4) ayant une ligne du système d'alimentation électrique agissant comme enroulement primaire (10) par laquelle peut circuler un courant à mesurer, un couplage transformateur entre l'enroulement primaire (10) et un enroulement secondaire (14) via un flux magnétique (12) commun qui forme un circuit magnétique ayant au moins un segment (28) constitué d'un matériau ayant une perméabilité relative, dans lequel une première tension partielle proportionnelle au changement temporel du courant côté primaire peut être induite dans l'enroulement secondaire,
   comprenant un transformateur de courant de commande (6) ayant un enroulement de commande (22) et un flux de commande (26) magnétique variable dans le temps qui n'est pas couplé avec le flux magnétique (12) dans le transformateur de courant de mesure (4), dans lequel le transformateur de courant de commande (6) est réglé de manière qu'un courant de commande ($i_{st}(t)$) variable dans le temps ayant une fréquence réglable circule par l'enroulement de commande (22), et forme un circuit magnétique de manière que le segment (28) du circuit magnétique du transformateur de courant de mesure (4) est formé comme segment (28) commun avec le circuit magnétique du transformateur de courant de commande (6) de sorte que le matériau formant le segment (28) commun est traversé par le flux de commande (26) et provoque, en relation avec une courbe caractéristique magnétique non linéaire, un changement de la perméabilité relative dans le matériau formant le segment (28) et, ainsi, une deuxième tension partielle induite dans l'enroulement secondaire (14), et

un moyen de traitement de signaux (41) qui a une résistance de charge ($R_B$) dans l'enroulement secondaire (14) du transformateur de courant de mesure (4) pour enregistrer une tension de mesure de la somme ($u_B(t)$), dans lequel le moyen de traitement de signaux (41) a un circuit d'évaluation (40) pour évaluer la tension de mesure de la somme ($u_B(t)$) enregistrée et le circuit d'évaluation (40) a une source de tension ($U_{st}$) commandée de manière synchrone au courant de commande ($i_{st}(t)$) variable et un multiplicateur (44), dans lequel le circuit d'évaluation (40) est réglé de manière que la tension de sortie de la source de tension ($U_{st}$) est fournie au multiplicateur (44) et est multipliée avec la tension de mesure de la somme ($u_B(t)$), et dans lequel le dispositif est réglé de manière que, afin de mieux enregistrer un premier signal de mesure (31) qui peut être attribué à la première tension partielle induite et le deuxième signal de mesure (32), la fréquence du courant de commande ($i_{st}(t)$) est commutée cycliquement entre au moins deux fréquences.

8. Dispositif selon la revendication 7,
   **caractérisé en ce que,**
   pour le découplage du flux magnétique (12) dans le transformateur de courant de mesure (4) et du flux magnétique (26) dans le transformateur de courant de commande (6), le transformateur de courant de mesure (4) et le transformateur de courant de commande (6) sont disposés de manière que les lignes d'induction magnétiques sont orthogonaux l'un par rapport à l'autre dans le segment (28) commun des deux circuits magnétiques.

9. Dispositif selon la revendication 7 ou 8,
   **caractérisé en ce que**
   la connexion entre le transformateur de courant de mesure (4) et le transformateur de courant de commande (6) dans le segment (28) des deux circuits magnétiques est formée avec ou sans un entrefer (9).

10. Dispositif selon l'une quelconque des revendications 7 à 9,
    **caractérisé en ce que**
    le moyen de traitement de signaux (41) a un circuit de filtrage (42), la tension de mesure de la somme ($u_B(t)$) enregistrée étant appliquée à l'entrée dudit circuit de filtrage (42) et ledit circuit de filtrage (42) étant réalisé comme filtre coupe-bande (42) à la fréquence réglée du courant de commande ($i_{st}(t)$) variable.

11. Dispositif selon l'une quelconque des revendications 7 à 10,
    **caractérisé en ce que**
    le transformateur de courant de commande (6) a une longueur de trajet magnétique la plus courte que possible.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1542025 A1
- EP 0579462 A2